# EUROPEAN PATENT APPLICATION

(11) **EP 1 579 956 A2**
(43) Date of publication of application: **28.09.2005**
(21) Application number: 05006662.0
(22) Date of filing: 24.03.2005
(51) Int. Cl.: B24B 37/04, B24B 57/02

(54) **Polishing apparatus and polishing method**

(30) Priority: 25.03.2004 JP 2004089296
(71) Applicant: KABUSHIKI KAISHA TOSHIBA, Tokyo 105-8001 (JP)
(72) Inventor: Terada, Takahiro, 1-1 Shibaura 1-chome Minato-ku Tokyo 105 (JP); Nakahata, Masaomi, 1-1 Shibaura 1-chome Minato-ku Tokyo 105 (JP); Nakagawa, Yasutada, 1-1 Shibaura 1-chome Minato-ku Tokyo 105 (JP)
(74) Representative: HOFFMANN EITLE

(57) **Abstract**

A polishing apparatus (10) includes a drive mechanism (22) for rotating a platen (21) in a direction R, a polishing liquid supply mechanism (40) for supplying a slurry L to a predetermined supply position P on a polishing pad (23), a polishing head (33) which is located downstream of the supply position P in a rotation direction of the platen (21) and which holds a wafer W such that the wafer W is opposed to the polishing pad (23), and a shuttering body (52) which is located downstream of the polishing head (33) in a rotation direction of the platen (21) and which removes the used slurry L from the platen (21).

## Description

The present invention relates to a polishing apparatus and a polishing method for polishing a thin film formed on a substrate, and more particularly, to a polishing apparatus and a polishing method using CMP (Chemical Mechanical Polishing).

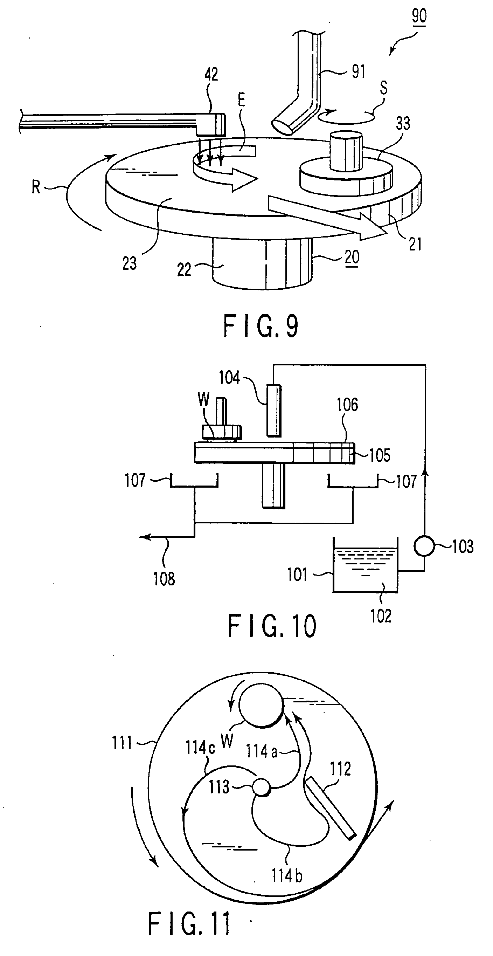

There are known conventional supply methods of polishing liquid in a polishing apparatus using the chemical mechanical polishing as shown in FIGS. 10 and 11. According to the method shown in FIG. 10, polishing liquid 102 in a storage tank 101 is supplied to a surface of a polishing pad 106 provided on a polishing platen 105 by a supply pump 103 through a supply member 104, and a wafer W is polished. Polishing liquid is splashed from the surface of the polishing pad 106 by a centrifugal force and flows into a funnel 107. This polishing liquid is not circulated and reused, and is discharged out as liquid waste 108.

According to the supply method of polishing liquid shown in FIG. 10, the polishing liquid 102 supplied to the polishing pad 106 is used only once and is disposed of as the liquid waste 108. Thus, there is a problem that the using cost of the polishing liquid is increased. Even if the using amount of polishing liquid is reduced to minimum degree, since polishing liquid for making the polishing pad 106 wet is necessary, reduction in working cost in the polishing procedure is limited.

Most of polishing liquid 102 supplied to the surface of the polishing pad 106 from the supply member 104 is splashed to periphery by the centrifugal force, the amount of polishing liquid 102 which is actually supplied to the wafer W is very small. Therefore, there is a problem that the using efficiency of the polishing liquid is low, and according to the polishing method shown in FIG. 10, most of the expensive polishing liquid is not used and is disposed of as liquid waste.

Thereupon, according to the method shown in FIG. 11, slurry scattered from the platen is stored on the platen as much as possible, thereby reducing the slurry amount. That is, a plate member 112 which moves toward a rotation center of a platen 111 is disposed on a surface of the polishing pad. With this, slurry supplied from a supply nozzle 113 is divided into three for example. Slurry 114a flows toward the wafer W and is used for polishing. Slurry 114b is scattered toward an outer peripheral side of the platen 111 but is stopped at an outer side of the plate member 112 in its radial direction and is collected, and is returned toward the central portion of the platen 111 and is used for polishing as with the slurry 114a. A slurry 114c is scattered toward the outer peripheral side of the platen 111.

It is an object of the present invention to enhance the using efficiency of polishing liquid supplied to a surface of a platen, thereby making it possible to polish a wafer with a small amount of polishing liquid.

The invention provides a polishing apparatus comprising; a platen provided at its upper surface with a polishing surface; a platen drive mechanism which rotates the platen around a rotation axis that is perpendicular to the polishing surface in a predetermined direction; a polishing composite supply mechanism which supplies polishing composite to a predetermined supply position of the polishing surface; a to-be-polished subject holding mechanism which is located downstream from the supply position in a rotation direction of the platen, and which holds the to-be-polished surface of the to-be-polished subject such that the to-be-polished surface is opposed to the polishing surface of the platen; and a polishing composite removing mechanism which is located downstream of the to-be-polished subject holding mechanism in a rotation direction of the platen, and which removes polishing composite supplied for polishing the to-be-polished subject from the platen.

According to the invention, in polishing operation using a platen, an amount of polishing pad, i.e., slurry to be used can be reduced.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a perspective view showing a polishing apparatus of the present invention;
FIG. 2 is an explanatory view showing motion of slurry and an amount of slurry on a platen incorporated in the polishing apparatus;
FIG. 3 is an explanatory view showing definition of angle of a shuttering body;
FIG. 4 is a graph showing a relation between PH of slurry and polish rate;
FIG. 5 is a graph showing variation in PH of slurry caused by polishing;
FIG. 6 is a graph showing a relation between a flow rate of slurry and polish rate;
FIG. 7 is a perspective view showing a modification of the polishing apparatus;
FIG. 8 is a perspective view showing further another modification of the polishing apparatus;
FIG. 9 is a perspective view showing another modification of the polishing apparatus;
FIG. 10 is a schematic side view of a conventional polishing apparatus; and
FIG. 11 is an explanatory view showing motion of slurry on a platen incorporated in the polishing apparatus.

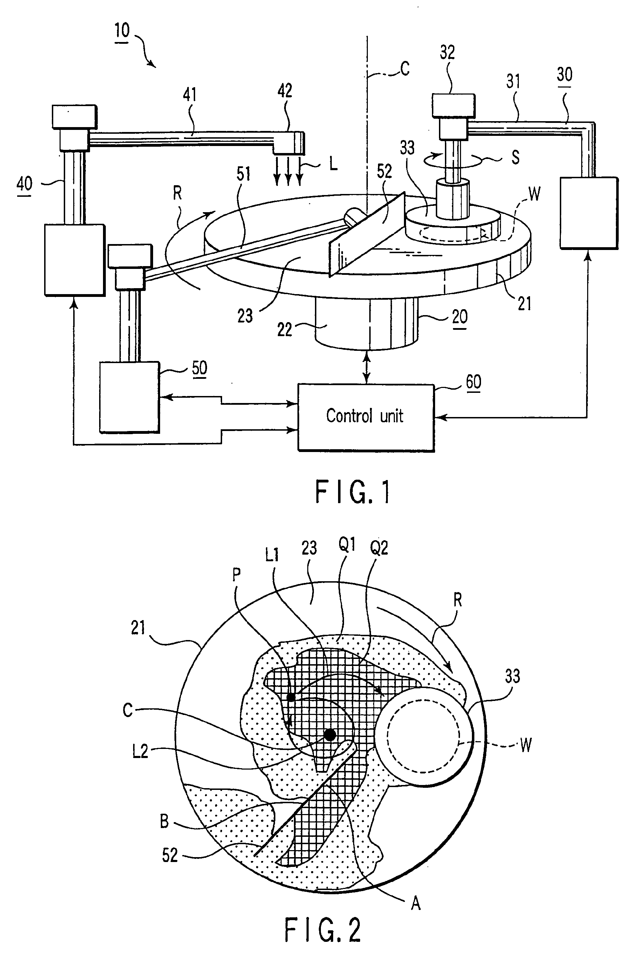

FIG. 1 is a perspective view showing the entire structure of a polishing apparatus 10 according to an embodiment of the present invention. The polishing apparatus 10 includes a platen mechanism 20, and a to-be-polished subject holding mechanism 30, a polishing liquid supply mechanism 40, a polishing liquid drain mechanism 50 which are all disposed around the platen mechanism 20. The polishing apparatus 10 also includes a control unit 60 which controls these mechanisms in liaison with each other.

The platen mechanism 20 includes a disk-like platen 21, and a drive mechanism 22 which rotates the platen 21 around a rotation axis C. A polishing pad 23 is pasted on an upper surface of the platen 21.

The to-be-polished subject holding mechanism 30 includes a first arm 31, a drive mechanism 32 supported by the first arm 31, and a polishing head 33 which is rotated by the drive mechanism 32 and holds a to-be-polished substrate such as a wafer. The polishing head 33 is opposed to the platen 21. The polishing head 33 can move on the platen 21 by the first arm 31 along a surface of the platen 21.

The polishing liquid supply mechanism 40 includes a second arm 41, and a supply nozzle (polishing liquid supply portion) 42 which is supported by the second arm 41. The supply nozzle 42 supplies slurry (polishing composite) L onto the platen 21. The supply nozzle 42 is opposed to the platen 21, and can move on the platen 21 by the second arm 41 along a surface of the platen 21.

The polishing liquid drain mechanism 50 includes a third arm 51, and a shuttering body 52 which is supported by the third arm 51 and which prevents slurry L on the platen 21 from being reused. The shuttering body 52 is opposed to the platen 21, and can move on the platen 21 by the third arm 51 along a surface of the platen 21. The shuttering body 52 is held at a predetermined angle and at a predetermined position which are determined as will be described later.

Preferable examples of material of the shuttering body 52 are polycarbonate, teflon resin and alkali-resistant material. When the shuttering body 52 is worn during use, it can be replaced by a new one.

The operation of the polishing apparatus 10 having the above-described structure will be explained. That is, the drive mechanism 22 is operated to rotate the platen 21 together with the polishing pad 23 (in the direction R in FIG. 1). The polishing liquid is supplied to a slurry supply position P on the polishing pad 23 from the supply nozzle 42. The third arm 51 positions the shuttering body 52 at a predetermined position on the polishing pad 23.

Next, the first arm 31 positions the polishing head 33 holding the wafer W at a location on the platen 21, and the drive mechanism 32 rotates the polishing head 33 (in the direction S in FIG. 1). With this, a to-be-polished surface of the wafer W, the polishing pad 23 and slurry L rub with each other and the to-be-polished surface of the wafer W is polished.

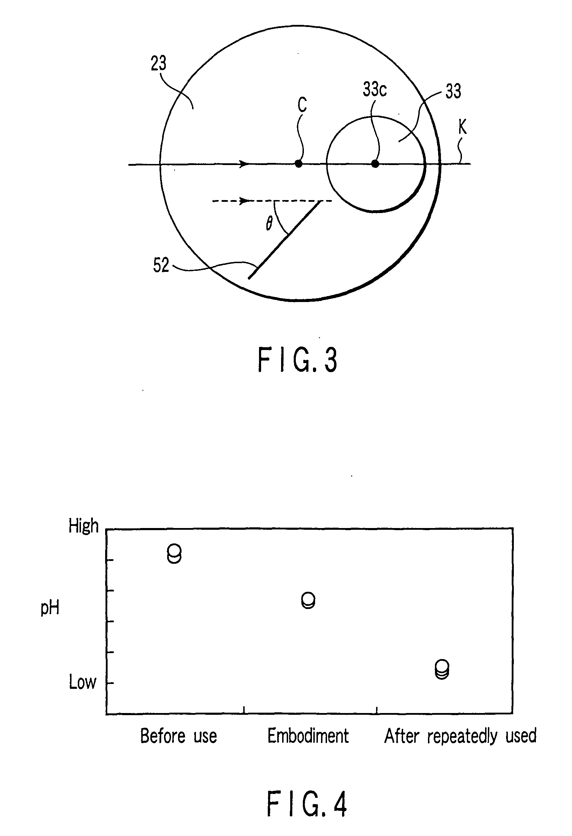

FIG. 2 shows motion of the slurry L on the platen 21 and the amount of the slurry L. That is, after the slurry L is supplied, the slurry L enters under the polishing head 33 (arrow L1 in FIG. 2), and the slurry L used for polishing is discharged (drained) from the platen 21 along a side A which is closer to the polishing head 33 of the shuttering body 52. After the slurry L is supplied, the slurry L which did not enter under the polishing head 33 and was not used for polishing collides against a side B of the shuttering body 52 closer to the slurry supply position P, and the slurry L again moves on the polishing pad 23 (arrow L2 in FIG. 2). The amount of slurry on the platen 21 is branched into a small region (Q1) and a large region (Q2) as shown in FIG. 2. The shuttering body 52 may be alternated by a brush to roughly separate the used slurry L from the unused slurry L.

Next, a position on the polishing pad 23 with respect to the shuttering body 52 will be defined. As shown in FIG. 3, if a reference line K connecting a rotation center of the platen 21 and a rotation center 33c of the polishing head 33 is set to 0°, and if a rotation direction of the platen 21 and the polishing head 33 is defined as a normal direction of angle, the inclination angle θ is set to -10 to -90°. If the platen 21 is divided into two region by the reference line K, the longitudinal length of the shuttering body 52 is longer in the region opposite from the slurry supply position P.

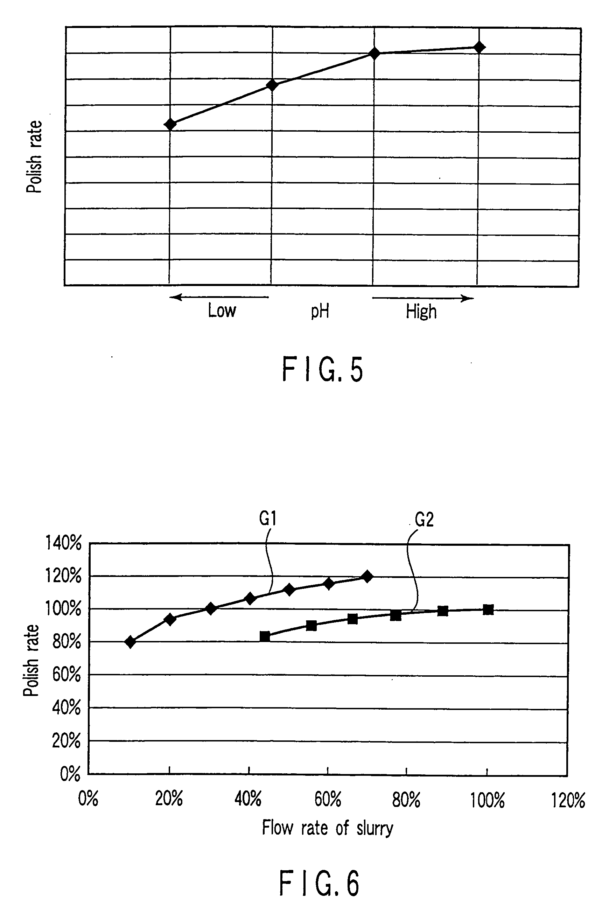

Here, a correlation between a PH value of the slurry L and a polish rate will be explained. As shown in FIG. 5, it can be found that there is such a relation that as the PH value of the slurry L is higher, the polish rate becomes higher. FIG. 4 shows that the PH value of slurry L before polishing is the highest, the PH value of slurry L introduced into the polishing head 33 of the polishing apparatus 10 is the second highest, and the PH value of slurry L which is repeatedly used is the lowest. FIG. 5 shows that if the PH value of slurry L is higher, the polish rate is higher. Thus, it can be found that the polish rate of slurry L used by the polishing apparatus 10 is higher than that of slurry L which is repeatedly used. Therefore, if slurry L which was used is not reused, the polishing efficiency can be enhanced.

Next, a correlation between a flow rate of the slurry L and the polish rate will be explained. FIG. 6 shows a graph G1 and a graph G2. The graph G1 shows a relation between the flow rate of the slurry L and the polish rate when the used slurry L is removed from the polishing apparatus 10 using the shuttering body 52. The graph G2 shows a relation between the flow rate of the slurry L and the polish rate when the shuttering body 52 is not used. From FIG. 6, it can be found that if the shuttering body 52 is used, about 30% of flow rate of slurry L suffices as compared with a flow rate when the shuttering body 52 is not used.

According to the polishing apparatus 10 having the above-described structure, if slurry L which was already used for polishing and which has low polishing efficiency is drained from the platen 21 using the shuttering body 52, only slurry L which is not used for polishing and which has high polishing efficiency can be supplied to the polishing head 33 which holds the wafer W. Thus, slurry L having low polishing efficiency is not mixed with slurry L having high polishing efficiency, the polishing efficiency is enhanced, and the wafer W can be polished with the small amount of slurry L.

Although the used slurry L is positively drained and is not reused in this embodiment, it is also possible to allow the drain means to function as separating means so that the unused slurry L is introduced for reuse. In the first embodiment, the shuttering body 52 has such a function.

Although the polishing apparatus 10 uses a platelike member as the shuttering body 52, the shuttering body 52 may be a plurality of annular walls, spiral walls or straight walls.

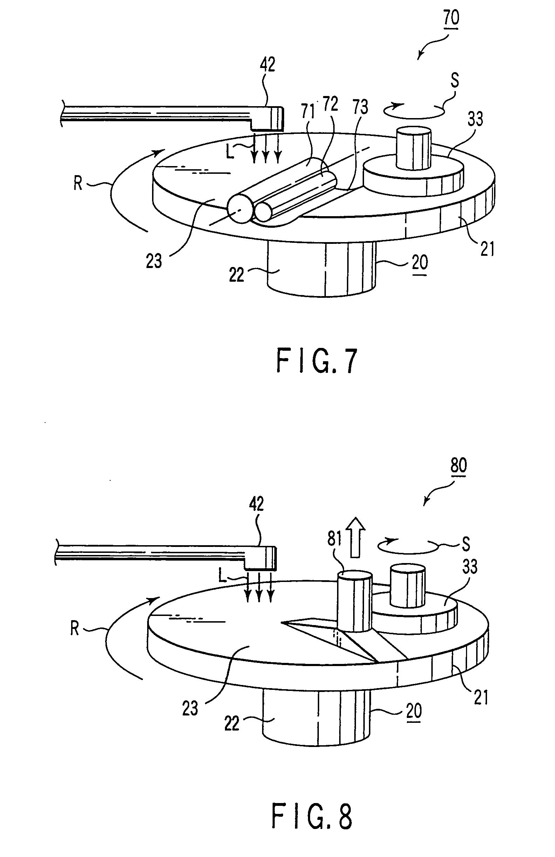

FIG. 7 is a perspective view showing a polishing apparatus 70 of a first modification of the polishing apparatus 10. In FIG. 7, the same function parts are designated with the same symbols as FIG. 1. Although the above-described polishing apparatus 10 uses the shuttering body 52, the polishing apparatus 70 absorbs the used slurry L by means of porous and breathable absorbing material such as sponge.

Provided on the platen 21 are a sponge roller 71 made of absorbing material capable of absorbing the slurry L, and a compression roller 72 which is opposed to the sponge roller 71 and which squeezes out the slurry L absorbed by the sponge roller 71, and a guttering 73 for discharging the squeezed out slurry L out from the platen 21. The sponge roller 71 and the compression roller 72 rotate in the opposite directions from each other.

In the polishing apparatus 70 having the above-described structure, the compression roller 72 squeezes the slurry L absorbed by the sponge roller 71. The squeezed out slurry L is drained by the guttering 73 from the platen 21. Thus, even with the polishing apparatus 70, the same effect as that of the polishing apparatus 10 can be obtained.

FIG. 8 is a perspective view showing a polishing apparatus 80 according to a second modification of the polishing apparatus 10. In FIG. 8, the same function parts are designated with the same symbols as FIG. 1. Although the above-described polishing apparatus 10 uses the shuttering body 52, the used slurry L is sucked out and removed in the polishing apparatus 80. On the platen 21 of the polishing apparatus 80, a suction nozzle 81 capable of sucking out the slurry L is disposed.

According to the polishing apparatus 80 having the above-described structure, the used slurry L is sucked and removed by the suction nozzle 81. Thus, even with the polishing apparatus 80, the same effect as that of the polishing apparatus 10 can be obtained.

FIG. 9 is a perspective view showing a polishing apparatus 90 according to a third modification of the polishing apparatus 10. In FIG. 9, the same function parts are designated with the same symbols as FIG. 1. Although the above-described polishing apparatus 10 uses the shuttering body 52, high pressure air blows the used slurry L off and remove the same in the polishing apparatus 90. An air nozzle 91 for blowing the slurry L with high pressure air E is disposed on the platen 21 of the polishing apparatus 90.

According to the polishing apparatus 90 having the above-described structure, the air nozzle 91 blows off the used slurry L and removes by the air nozzle 91. Thus, even with the polishing apparatus 90, the same effect as that of the polishing apparatus 10 can be obtained.

The shuttering body 52, the sponge roller 71 and the like which can prevent the used slurry L from being reused can be replaced by another member.

## Claims

1. A polishing apparatus (10) **characterized by** comprising;
a platen (21) provided at its upper surface with a polishing surface;
a platen drive mechanism (22) which rotates the platen (21) around a rotation axis C that is perpendicular to the polishing surface in a predetermined direction R;
a polishing composite supply mechanism (40) which supplies polishing composite L to a predetermined supply position P of the polishing surface;
a to-be-polished subject holding mechanism (30) which is located downstream from the supply position P in a rotation direction R of the platen (21), and which holds a to-be-polished surface of a to-be-polished subject W such that the to-be-polished surface is opposed to the polishing surface of the platen (21); and
a polishing composite removing mechanism (50) which is located downstream of the to-be-polished subject holding mechanism (30) in the rotation direction R of the platen (21), and which removes a polishing composite L supplied for polishing the to-be-polished subject W from the platen (21).

2. The polishing apparatus (10) according to claim 1, **characterized in that** the polishing composite removing mechanism (50) can adjust at least one of attitude and position.

3. The polishing apparatus (10) according to claim 1, **characterized in that** the polishing composite removing mechanism (50) is a guide member (52) for guiding the polishing composite L on the platen (21) radially outward of the platen (21).

4. The polishing apparatus (10) according to claim 3, **characterized in that** the guide member (52) is inclined, through -10 to -90°, with respect to a reference line K which connects a rotation center of the platen (21) and a rotation center of the to-be-polished subject W when the rotation direction R is defined as a normal direction, and the guide member (52) is provided in a region opposite from the supply position P with respect to the reference line K.

5. The polishing apparatus (70) according to claim 1, **characterized in that** the polishing composite removing mechanism is a porous and breathable absorbing material (71) which absorbs and removes the polishing composite L on the platen (21).

6. The polishing apparatus (80) according to claim 1, **characterized in that** the polishing composite removing mechanism is a suction mechanism (81) which sucks and removes the polishing composite L on the platen (21).

7. The polishing apparatus (90) according to claim 1, **characterized in that** the polishing composite removing mechanism is high pressure air blower (91) which blows high pressure air on the polishing composite L on the platen (21) and drains the same in an outer peripheral direction of the platen (21).

8. A polishing method **characterized by** comprising;
a platen driving step of rotating a platen (21) around a rotation axis which is perpendicular to a polishing surface provided on an upper surface of the platen (21) in a predetermined rotation direction R;
a polishing composite supplying step of supplying a polishing composite L to a predetermined supply position P of the polishing surface;
a to-be-polished subject holding step which is located downstream from the supply position P in a rotation direction of the platen (21), and in which the to-be-polished surface of the to-be-polished subject W is held such that the to-be-polished surface is opposed to the polishing surface of the platen (21); and
a polishing composite removing step which is located downstream of the to-be-polished subject holding mechanism (30) in a rotation direction R of the platen (21), and in which the polishing composite L supplied for polishing the to-be-polished subject W is removed from the platen (21).
